(19) Europäisches Patentamt
European Patent Office
Office européen des brevets

(11) **EP 3 792 587 B1**

(12) **EUROPÄISCHE PATENTSCHRIFT**

(45) Veröffentlichungstag und Bekanntmachung des Hinweises auf die Patenterteilung:
**20.03.2024   Patentblatt 2024/12**

(21) Anmeldenummer: **20192202.8**

(22) Anmeldetag: **21.08.2020**

(51) Internationale Patentklassifikation (IPC):
*G01B 7/004* (2006.01)   *G01B 7/02* (2006.01)
*G01B 7/04* (2006.01)   *G01B 7/30* (2006.01)
*G01D 5/14* (2006.01)   *G01D 5/249* (2006.01)
*G01D 5/165* (2006.01)

(52) Gemeinsame Patentklassifikation (CPC):
**G01B 7/004; G01B 7/023; G01B 7/046; G01B 7/30;**
G01D 5/145; G01D 5/165; G01D 5/2495

(54) **VERFAHREN ZUR MESSUNG DER AUSRICHTUNG ZWISCHEN ZWEI KÖRPERN**

METHOD FOR MEASUREMENT OF THE ORIENTATION BETWEEN TWO BODIES

PROCÉDÉ DE MESURE DE L'ORIENTATION ENTRE DEUX OBJETS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.08.2019   AT 2762019**

(43) Veröffentlichungstag der Anmeldung:
**17.03.2021   Patentblatt 2021/11**

(73) Patentinhaber: **SuessCo Sensors GmbH**
**3130 Herzogenburg (AT)**

(72) Erfinder: **Windl, Roman**
**3133 Traismauer (AT)**

(74) Vertreter: **Ellmeyer, Wolfgang**
**Häupl & Ellmeyer KG**
**Patentanwaltskanzlei**
**Mariahilfer Strasse 50**
**1070 Wien (AT)**

(56) Entgegenhaltungen:
**EP-A1- 2 863 184        EP-A1- 3 021 088**
**WO-A1-00/23824        WO-A1-2005/047823**
**WO-A1-2009/121193     WO-A1-2017/162231**
**DE-A1-102015 203 686   US-A1- 2004 017 187**

EP 3 792 587 B1

**Beschreibung**

Die Erfindung betrifft das Messen von Positionen im Raum, mechanischer Verschiebungen und Rotationen und insbesondere eine dafür geeignete Methode entsprechend dem einleitenden Teil des Anspruches 1.

Verschiedene technische Realisierungen sind Stand der Technik für lineare Positionssensoren (Wegsensoren). Auf Widerstandsänderung basieren Potentiometergeber und Dehnungsmessstreifen. Eine Positionsänderung führt bei induktiven Sensoren zu einer Veränderung der Induktivität. Ein derartiger Sensor ist aus der SE 9 501 500 A zur Messung einer Kraft, die auf eine Platte wirkt, bekannt. Dabei drückt die Platte auf den Kern einer elektrischen Spule, der ein magnetostriktives Material aufweist oder zumindest teilweise aus ihm besteht. Durch die Änderung der Geometrie zufolge der Kraft ändern sich die magnetischen Eigenschaften des Kerns, was über die Spule und eine Auswertungselektronik gemessen wird. Daraus kann auf die Kraft rückgeschlossen werden.

Andere Sensoren mit magnetostriktivem Material sind aus WO 2004/070408 A, der JP 2005338031 A, der JP 8293012 A und der US 2002166382 A bekannt.

Andere Bauformen für Weggeber sind kapazitiven Sensoren, bei denen eine Positionsänderung der Kondensatorplatten beziehungsweise des Dielektrikums zu einer Änderung der Kapazität führen.

Weiters kann eine Distanz mittels Laufzeitmessung bestimmt werden, wie beispielsweise bei Laserentfernungsmesser, oder Ultraschallsensoren. Bei magnetostriktiven Wegaufnehmern wird der Abstand eines ringförmigen Magnetes durch Laufzeitmessung einer Torsionswelle in einem Rohr bestimmt. In Anwendung für "Structural Health Monitoring" werden oft Schwingseitensensoren angewendet.

Eine weitere Klasse von Wegsensoren basierten auf Inkrementalgeber. Hier werden periodische Maßverkörperungen (bei optischen Systemen Striche auf Glas oder Metall, bei magnetischen Systemen Magnetisierung auf einem Magnetband) durch eine Elektronik gezählt. Der Nachteil dieser Systeme ist, dass keine absolute Messung der Position möglich ist.

Um absolute Positionen in einer Richtung (einer Dimension) bestimmen zu können, wird die aktuelle Position durch ein magnetisches Bitmuster codiert. Dies kann beispielsweise durch die Verwendung einer zweiten Spur oder durch das Phasenverhältnis zwischen den Spuren realisiert werden (DE10038296A1, US20180306601A1). Um dieses Bitmuster auslesen zu können, werden magnetische Sensoren verwendet. Um die absolute Position bestimmen zu können, müssen mehr als eine Feldkomponente ausgelesen werden und somit auch mehr als ein Magnetfeldsensor verwendet werden.

Eine andere Möglichkeit ist aus dem Magnetfeld eines Permanentmagneten auf die Position relativ zu einem Magnetfeldsensor zu schließen. Aus im allgemeinen zwei Komponenten des Magnetfeldes (Ortner, M., et al. "Application of 3D-printed magnets for magnetic position detection systems." 2017 IEEE SENSORS. IEEE, 2017.) kann auf die Position einer Richtung geschlossen werden.

Das Dokument DE102015203686 A1 offenbart ein Verfahren zum Messen der Ausrichtung zwischen zwei Körpern gemäss dem Stand der Technik.

All diese zuvor beschriebenen Verfahren haben gemein, dass diese die Position nur in einer Richtung (Dimension) bestimmen können.

Für eine Vielzahl von Anwendungen ist jedoch die 3D-Bestimmung der Position von Bedeutung. Als Beispiel sei genannt die Stellung eines Steuerknüppels. die Bewegung von Bauteilen zueinander (Rissmonitore), die genaue Position von Roboterarmen und Maschinenteilen.

Die Erfindung hat die Aufgabe, dieses Problem zu lösen und schlägt dazu vor, absolute mechanische Positionen, Verschiebungen und Rotationen zwischen zwei räumlich und mechanisch getrennten Objekten zu detektieren. In einer Ausprägung der Anmeldung kann diese Bestimmung auch passiv erfolgen, das heißt der erfindungsmäßige Sensor benötigt keine Batterie. In diesem Fall ist der Sensor so ausgeführt, dass er als passives Element funktioniert, das weder eine eigene Energieversorgung noch sonstige elektronische Elemente benötigt. Dieses System kann mit handelsüblichen Lesegeräten ausgelesen werden zu können, wie beispielsweise ein kommerzielles Mobiltelefon mit NFC Funktionalität.

In der Erfindung wird auf die räumliche Position eines Permanentmagnetsystems (6) anhand der gemessenen Magnetfelder zurückgerechnet, wobei die Magnetfelder durch Magnetfeldsensoren detektiert werden. Dies ermöglicht eine absolute Erfassung der Position in 6 Dimensionen, nämlich 3 Positionen (x,y,z) und 3 Rotationswinkel (3 Eulerwinkel, $\alpha,\beta,\gamma$). Absolut bedeutet in diesem Kontext, dass der Nullpunkt der Position immer bekannt ist, dies ist ein Vorteil gegenüber relativen Messverfahren, die bei Stromverlust oder Messfehlern einen Referenzpunkt zur Festlegung des Nullpunktes anfahren müssen.

Eine Ausgestaltung der Erfindung kann die folgenden wesentlichsten Bestandteile des Systems enthalten:

(i) Einen Mikro-Chip (4) welcher analoge oder digitale Auswertung von verschiedensten Magnetfeldsensoren (3) bietet, die ID des Sensors speichert und über drahtlose Ausleseeinheiten wie Bluetooth oder RFID verfügt.

(ii) Ein oder mehrere Magnetfeldsensoren (3), die mindestens eine Komponente des Magnetfeldes bevorzugt aber alle drei Komponenten des Magnetfeldes messen. Weitere Sensoren wie z.B. Temperatursensoren können verwendet werden, um die Genauigkeit der Messung zu erhöhen, indem eine Temperaturkompensation durchgeführt wird.

(iii) Mindestens ein Permanentmagnet (6) welcher in Form und Magnetisierung bekannt ist und von dem die Position absolut zu den Magnetfeldsensoren bestimmt wird.

(iv) Optional kann der Sensor mit einer Batterie (10) ausgestattet zu sein, sodass auch unabhängig vom Lesesignal Messdaten aufgezeichnet werden können.

Durch das Funksignal des Abfragegeräts kann ein passiver RFID-Transponder genügend Energie beziehen, um einen Magnetfeldsensor (3) auszulesen. Als Magnetfeldsensor können Standardsensoren wie beispielsweise Hall, AMR, GMR, TMR Sensoren verwendet werden.

Das magnetische Streufeld $H_{\text{Messung}}$ des Permanentmagnetsystems (6) wird vorab gemessen oder mittels mathematischer Methoden simuliert. Die Magnetfeldsensoren werden so angeordnet, dass ein gewünschter Verschiebungsbereich mit einer gewünschten Auflösung gemessen werden kann. Durch Erhöhung der Anzahl der Magnetfeldsensoren (3) kann der Verschiebungsbereich vergrößert oder die Positionsgenauigkeit verbessert werden. Eine Reduzierung der Anzahl der Magnetfeldsensoren reduziert den Verschiebungsbereich oder verschlechtert die Positionsgenauigkeit.

Die Messwerte der Magnetfeldsensoren werden mit ihren bekannten Positionen an ein Rechenmodell übergeben, welches aufgrund des magnetischen Streufeldes des Permanentmagnetsystems (6) auf die Position in Relation zu den Magnetfeldsensoren rückrechnen kann.

Im Folgenden wird eine Ausprägung im Detail beschrieben. Die Permanentmagnete (6) erzeugen an den Positionen $x_i$ der Sensoren ein Magnetfeld $H_{\text{Messung,i}}$. Andererseits kann bei bekannter Geometrie, Anordnung der Magnete zueinander, gegebener Magnetisierung $M$ der Permanentmagnete, für eine bestimmte Position des Magnetsystems $x_{\text{Magnet}}$ und einer bestimmten Rotationsausrichtung im Raum, welche beispielsweise durch die Eulerwinkel $\alpha,\beta,\gamma$ definiert ist, das erwartet Magnetfeld an den Orten $x_i$ bestimmt werden, $H_{\text{Theorie,i}}$ (XMagnet, $\alpha,\beta,\gamma$).

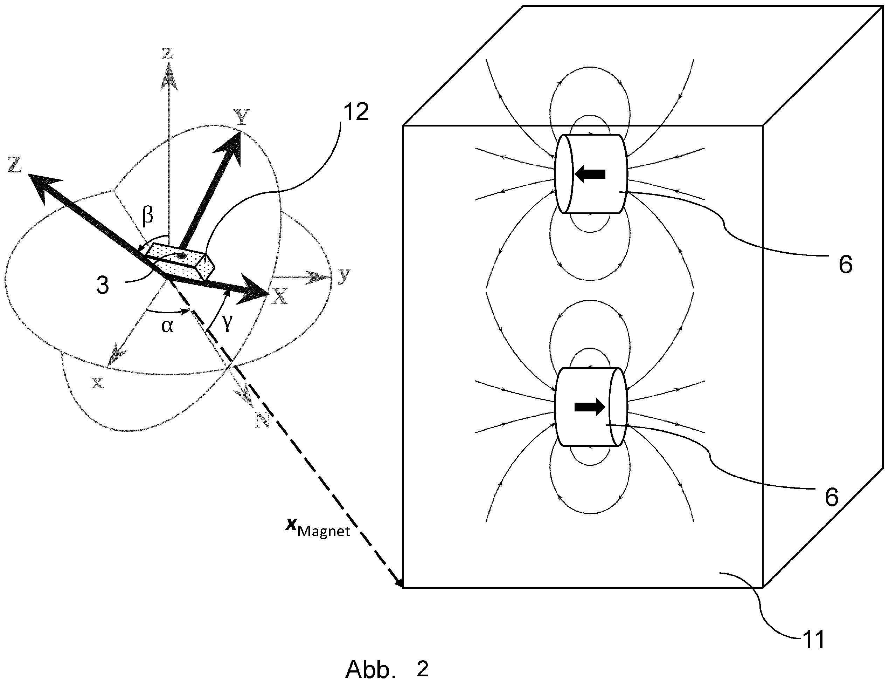

Beispielshaft sind in Abb. 2 die Winkel des Gehäuses (12) der Magnetfeldsensoren (3) und der Halterung (Gehäuse) (11) der Permanentmagnete (6) dargestellt. Die Distanz zwischen dem Gehäuse (12) und dem Gehäuse der Permanentmagnete (11) ist der Betrag des Vektors $x_{\text{Magnet}}$. Die Winkellage im Raum von Objekt 3 ist mit den Eulerwinkel $(\alpha,\beta,\gamma)$ dargestellt.

Selbstverständlich kann auch das Gehäuse (12) der Magnetfeldsensoren als fixes Koordinatensystem definiert werden und die Winkellage des Gehäuses (11) also des Magnetsystems durch Eulerwinkel $(\alpha,\beta,\gamma)$ beschrieben werden. Der Vektor $x_{\text{Magnet}}$ beschreibt die relative örtliche Verschiebung dieser beiden Gehäuse.

Aus dem gemessenen Magnetfeld und dem erwarteten Magnetfeld, falls das Permanentmagnetsystem (6) am Ort $x_{\text{Magnet}}$ ausgerichtet ist und die Drehung im Raum durch die Eulerwinkel $(\alpha,\beta,\gamma)$ gegeben ist, wird eine mathematische Norm (Abstand $d$) zwischen diesen beiden Felder bestimmt

$$d\left(\mathbf{x}_{Magnet}, \alpha, \beta, \gamma\right) = \sum_{i=1}^{N} \left\|\mathbf{H}_{Theorie,i}\left(\mathbf{x}_{Magnet}, \alpha, \beta, \gamma\right) - \mathbf{H}_{Messung,i}\right\|, \qquad (1.1)$$

wobei N die Anzahl der Magnetfeldsensoren an den Orten $x_i$ ist. Die unbekannte Position $x_{\text{Magnet}}$ des Permanentmagnetsystems (6) und Ausrichtung im Raum $\alpha,\beta,\gamma$ wird derart bestimmt, dass der Abstand $d$ minimiert wird. In die Abstandfunktion $d$ können noch weitere unbekannte Größen implementiert werden, wie beispielsweise Sensorsensitivität in die $x,y$ und z Richtung, Temperaturabhängige Magnetisierung und der gleichen. Solange die gemessenen Feldwerte der Sensoren größer als die Anzahl der Unbekannten ist, kann das System eindeutig gelöst werden. Verschiedene Normen können verwendet werden, wie die Euklidische Norm, Summennorm, p-Norm, Betragsnorm oder Matrixnorm.

Natürlich kann die Rotation ist Raum nicht nur durch Eulerwinkel beschrieben werden, sondern auch durch Quaternionen oder jede andere Größe, die die Rotationslage auf einzigartige Weise beschreibt. Wenn nur die Position im Raum, nicht aber die Rotation im Raum bestimmt werden soll, kann die Distanzfunktion wie folgt verwendet werden

$$d\left(\mathbf{x}_{Magnet}\right) = \sum_{i=1}^{N} \left\|\mathbf{H}_{Theorie,i}\left(\mathbf{x}_{Magnet}\right) - \mathbf{H}_{Messung,i}\right\|, \qquad (1.2)$$

Um die Unbekannten Komponenten des Vektors $x_{\text{Magnet}}$ auf der linken Seite von Gl. 1.2 zu erhalten, muss der Abstand $d$ minimiert werden. Der Positionsvektor $x_{\text{Magnet}}$, kann nur aus der x Komponente bestehen, der $x$ und $y$

Komponente oder der *x*, *y* und *z* Komponente.

Die Ausrichtung im Raum wird allgemein mit einem Vektor $y_{Magnet}$ beschrieben der sowohl den Positionsvektor als auch die Winkellage beinhaltet, $y_{Magnet}=(x_{Magnet}, \alpha,\beta,\gamma)$. In weiteren Ansprüchen wird diese Ausrichtung im Raum verallgemeinert, dass weiter Unbekannte wie Temperatur $T$, oder Sensitivität der Magnetfeldsensoren in alle Richtungen $(S_x, S_y, S_z)$ in diesem Vektor $y_{Magnet}=(x_{Magnet}, \alpha,\beta,\gamma, T, S_x, S_y, S_z)$ vorkommen. Hier muss lediglich in das Berechnungsmodell zur Bestimmung von $H_{Theorie}$, der Einfluss dieser zusätzlichen Größen auf das erwartetet gemessene Feld $H_{Theorie}$ bekannt sein und berücksichtigt werden in der Berechnung von $H_{Theorie}$. Für die Distanzfunktion folgt:

$$d\left(\mathbf{y}_{Magnet}\right) = \sum_{i=1}^{N} \left\| \mathbf{H}_{Theorie,i}\left(\mathbf{y}_{Magnet}\right) - \mathbf{H}_{Messung,i} \right\|, \qquad (1.3)$$

Die Unbekannten aller Komponenten des Vektors $y_{Magnet}$ werden erhalten, indem der Abstand $d$ minimiert wird. Es sei angemerkt, dass der Vektor $y_{Magnet}$ weiter Ausrichtung im Raum genannt wird, obwohl dieser nicht nur Lagekoordinaten und Rotationswinkel beinhaltet sondern auch weitere Größen wie T und $S_x$ usw. Weiters ist es möglich eine weiter Unbekannte in der Berechnung von $H_{Theorie}$ einzuführen, nämlich, dass jede Komponente des theoretischen Feld $H_{Theorie}$ mit einem Faktor $\xi$ skaliert wird. Dieser Faktor beschreibt beispielsweise näherungsweise eine mit der Temperatur abhängigen Magnetisierung oder mit der Temperatur abhängigen Sensitivität der Magnetfeldsensoren. Dieser Faktor ist eine weitere Unbekannte die in der Minimierung des Abstandes $d$ mitbestimmt wird.

Diese Minimierung wird im Allgemeinen numerisch durchgeführt und es können verschiedene Minimierungsroutinen wie Nelder-Mead, Powell Minimierung, konjugierte Gradienten, BFGS (Broyden-Fletcher-Goldfarb-Shanno) Minimierung . Auch globale Minimierungsmethoden können verwendet werden wie, "Basinhopping", Evolutionäre Algorithmen, oder "Simulated Annealing".

Das magnetische Feld $H_{Theorie}$ des Permanentmagnetsystems (6) kann entweder analytisch oder auch numerisch mit Hilfe von Randelementmethoden oder finiten Elementmethoden berechnet werden. Bei numerischen Berechnungsmethoden können die makroskopischen Maxwellgleichungen gelöst werden, sodass Selbstentmagnetisierungseffekte der Magnete oder andere weichmagnetische Materialien berücksichtigt werden können.

Darüber hinaus können "Machine Learning" Methoden verwendet werden, um für mehrere Messwerte $H_{Messung}$ die Ausrichtung im Raum $y_{Magnet}$ vorherzusagen. Dazu wird für verschiedene bekannte Ausrichtungen im Raum $y_{Magnet}$ das Magnetfeld an den Sensorpositionen $H_{Theorie,i}$ ($y_{Magnet}$) ausgewertet. Diese Auswertung kann entweder durch Simulationen oder Messungen des realen Systems erfolgen oder beide Ansätze in einer "Machine Learning" Methode kombiniert werden, wie z.B. Data Fusion "Machine Learning". Für diese bekannten Felder $H_{Theorie,i}$ wird die "Machine Learning" Methode mit den ebenfalls bekannten Ausrichtungen im Raum $y_{Magnet}$ trainiert. Dadurch ist das maschinell gelernte System in der Lage, für das gemessene Feld $H_{Messung}$ die Ausrichtung des Magneten $y_{Magnet}$ vorherzusagen.

Es können verschiedene "Machine Learning" Methoden verwendet werden, wie "Gradient Boost", neuronale Netze, oder andere Methoden für Regressions- und Klassifikationsprobleme.

Es können auch die Methoden von "Machine Learning" und die Minimierung des Problems gemäß Gleichung (1.3) kombiniert werden. So kann beispielsweise die Vorhersage der "Maschine Learning" Methode, also der Vektor $y_{Magnet}$, als Input für die Startposition $y_{Magnet,0}$ der Gleichung (1.3) verwendet werden, die dann mit einem Minimierungsverfahren minimiert wird.

Eine andere Methode um $H_{Theorie,i}$ ($x_{Magnet}, \alpha,\beta,\gamma$) zu bestimmen ist, dass vorab das magnetische Feld des Permanentmagnetsystem vermessen wird und die magnetischen Feldwerte als Funktion des Raumes gespeichert werden, $H_{Theorie,i,0}$ ($x_{Magnet}=0, \alpha=0,\beta=0,\gamma=0$). Durch Anwendung von Translationsoperationen und Drehoperationen kann aus dem vorab bestimmten Feld $H_{Theorie,i,0}$ auf $H_{Theorie,i}$ ($x_{Magnet}, \alpha,\beta,\gamma$) geschlossen werden.

Diese Methode kann auch verwendet werden, wenn das Permanentmagnetsystem (6) auf beispielsweise einer weichmagnetischen Abschirmung (66) angebracht sind. Hier wird das gesamte Magnetfeld von Permanentmagnete (6) und weichmagnetische Abschirmung (66) simuliert oder vermessen. Diese weichmagnetischen Abschirmung kann als Plättchen ausgebildet sein oder in jeglicher anderen geometrischen Form.

Die erfindungsgemäßen Sensoren sind auch für drahtlose Spannungsmessungen und Verschiebungsmessungen geeignet und insbesondere dort einsetzbar, wo eine Verkabelung nur mit hohem Aufwand und/oder mit Einschränkungen in der Anwendung durchführbar ist.

Die Erfindung wird im Folgenden anhand der Zeichnung näher erläutert. Dabei zeigt, bzw. zeigen, ganz schematisch:

Abb. 1 eine erfindungsgemäße Vorrichtung zur Messung von Verschiebungen mit vier Magneten
Abb. 2 Beispiel der Eulerwinkel ($\alpha,\beta,\gamma$) des Sensorsystems (3) und beispielshafte Magnetfeldverteilung der Permanentmagnete (6).
Abb. 3 eine Vorrichtung zur Messung von Verschiebungen mit einem Magneten

Abb. 4 eine Variante zur Messung von Verschiebungen zwischen zwei Körpern mit einer anderen Anordnung der Magnete

Abb. 5 eine Variante zur Messung von Verschiebungen zwischen zwei Körpern mit einer anti-parallelen Ausrichtung der Magnetisierung der Magnete

Abb. 6 eine Variante zur Messung von Verschiebungen zwischen zwei Körpern mit einer Halbach Magnetisierung der Magnete

Abb. 7 eine Variante der Magnetisierung der Permanentmagnete, wobei ein "pseudo random code" verwendet wird.

Abb. 8 eine Variante der Magnetisierung der Permanentmagnete, wobei an jeder Position $p_1$ ein eindeutiges Bitmuster in y-Richtung existiert.

Abb. 9 eine Variante der Magnetisierung der Permanentmagnete, wobei an jeder Position $p_1$ ein eindeutiges Bitmuster in der $x,y$ Ebene existiert.

Abb. 10 eine Variante zur Messung von Verschiebungen zwischen zwei Körpern wobei die Magnete näher an den Körper angebracht sind als die Sensoren und unter den Magneten ein optionales weichmagnetisches Element (weichmagnetische Abschirmung) angebracht ist

Abb. 11 eine Variante zur Messung des mechanischen Druckes auf den Körper (7)

Abb. 12 eine Variante zur Feststellung der Lage und Position eines Steuerknüppels

Abb. 13 eine Variante zur Feststellung der Abweichung einer gelagerten Welle

Abb. 14 eine Variante zur Messung von Verschiebungen zwischen drei Körpern

Abb. 15 eine Variante zur Messung von Dehnungen eines Körpers

Abb. 16 Mögliche Komponenten eines Mikro-Chips

Abb. 17 zeigt den Vergleich der gemessenen Position des Permanentmagneten zu dem vorgegebenen linearem Verhalten

Abb. 18 zeigt Anordnung von Magneten und Sensoren eines weiteren konkreten Beispiels

Abb. 19 zeigt die Standardabweichung der x-Position der Verschiebung

Abb. 20 zeigt die Standardabweichung des Winkels $\alpha$

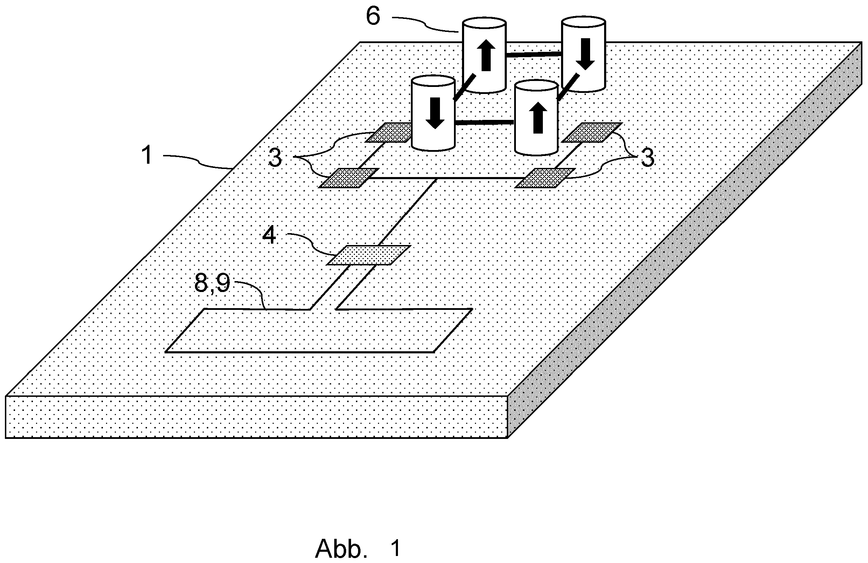

Abb. 1 zeigt die erfindungsgemäßen Sensorvorrichtung (1) bestehend aus mehreren Magnetfeldsensoren (3), einem Mico-Chip (4), der einen RFID Transponder mit einer eine Antenne (9) oder eine Kabelverbindung (8) besitzt und den Permanentmagneten (6). Die Permanentmagneten haben eine fixe Ausrichtung zueinander und sind an einem zweiten Körper (7) befestigt, wobei die relative Position von Körper (7) zu Körper (1) bestimmt wird. Die Magnetfeldsensoren (3) messen das aktuelle Magnetfeld $H_{\text{Messung},i}$ des Permanentmagnetsystems (6) am Ort des i-ten Sensors $x_i$. Dieses Feld wird vom Mikro-Chip (4) mit dem simulierten oder zuvor vermessenen Magnetfeld des Permanentmagnetsystems $H_{\text{Theorie}}$ verglichen. Daraus wird eine Abstandsnorm $d$ bestimmt um durch Minimierung der Unbekannten, also der Ausrichtung im Raum (Euler Winkel) und die Position des Permanentmagnetsystems (6) bestimmen zu können. Dies bedeutet, dass die Position und Rotation des Permanentmagnetsystems (6) relativ zu den Magnetfeldsensoren (3) ohne mechanische Verbindung berechnet werden kann.

Ein oder mehrere Permanentmagnete (6) sind in einer Halterung (11) auf dem zu vermessenden Körper (7) angebracht. Die Magnetfeldsensoren (3) sowie der Micro-Chip (4) werden gemeinsam in einem Gehäuse (12) platziert und auf demselben Körper (7), oder auf einem mechanisch getrennten Körper (77) angebracht.

Die Permanentmagnete können direkt verklebt oder aufgeschraubt mit einem Gehäuse befestigt oder direkt in den zu vermessenden Körper integriert werden.

Aufgrund der Verwendung von mehreren Magnetfeldsensoren (3) können externe Störeinflüsse wie das Erdmagnetfeld oder Temperaturen kompensiert werden. Um den Einfluss von Temperatur auf das Sensorsignal noch weiter zu kompensieren, kann ein Micro-Chip (4) mit internen oder externen Temperatursensor verwendet werden. Durch die Kenntnis der aktuellen Temperatur kann der temperaturabhängige gemessene Widerstandswert des Magnetfeldsensors kompensiert werden.

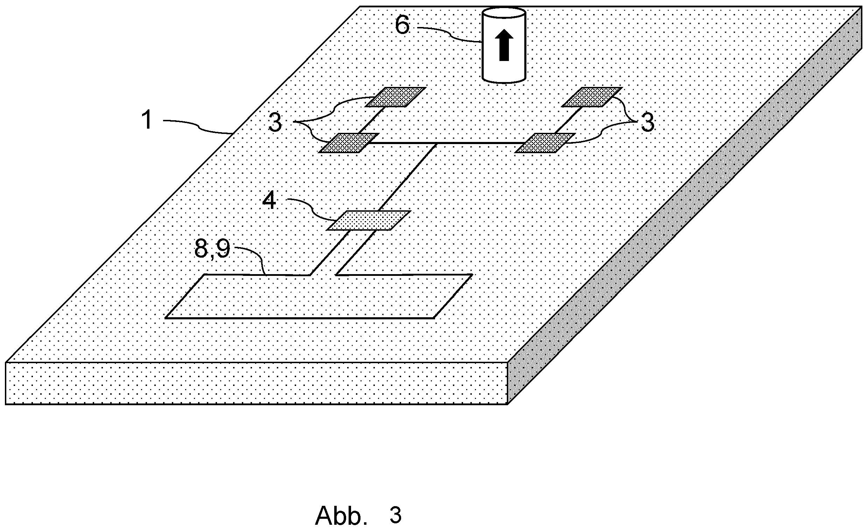

In Abb. 3 ist eine Ausprägung der Erfindung gezeigt, wo nur ein Permanentmagnet verwendet wird um auf die Position zwischen den Magneten (6) und dem Sensorarray (3) zu schließen. Eine mögliche Rotation des Magneten (6) um seine Symmetrieachse kann nicht detektiert werden, da das Magnetfeld um diese Achse rotationssymmetrisch ist.

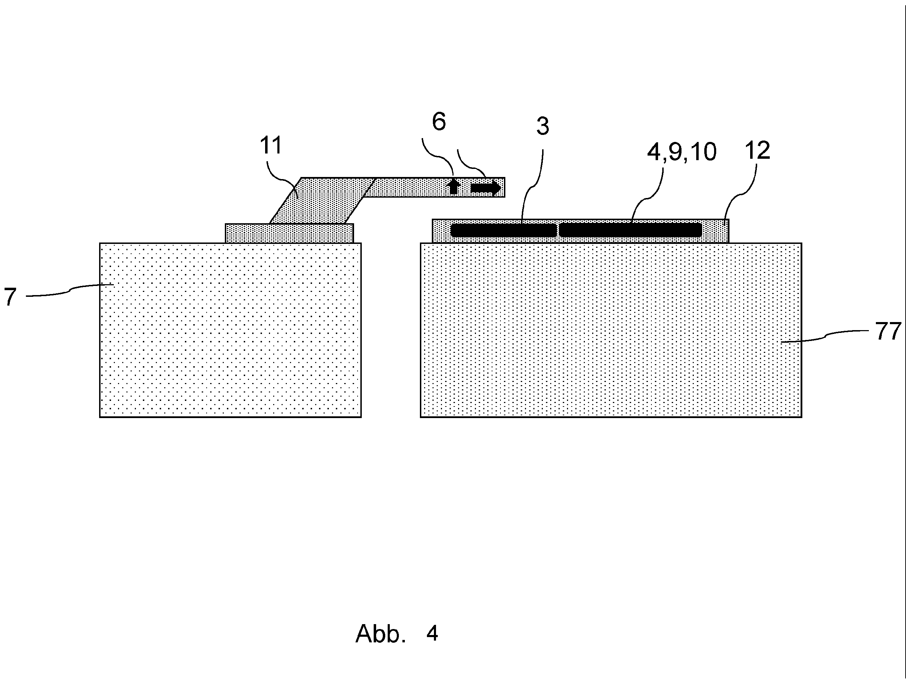

Abb. 4 stellt eine Ausprägung des in Abb. 1. beschriebenen Sensors zur Messung des Abstandes und der Winkelverdrehung zwischen dem Referenzkörper (77) und dem zu messenden Körper (7) dar. Die Permanentmagnete (6) haben eine Magnetisierung, die nicht parallel zueinander steht. Die Permanentmagnete (6) sind mittels einer Halterung (11), welche verschiedenste geometrische Formen und Größen annehmen kann, über den Magnetfeldsensoren (3) platziert. Die Magnetfeldsensoren (3) werden gemeinsam mit dem Mikro-Chip (4), der Antenne (9) und optional einer Batterie (10) in einem Gehäuse (12) bzw. einer Schutzhülle (12) zusammengefasst. Verschiebungen und Rotationen zwischen dem Referenzkörper (77) und dem zu messenden Körper (7) können über die mathematische Rückrechnung wie für Fig.1. beschrieben durchgeführt werden.

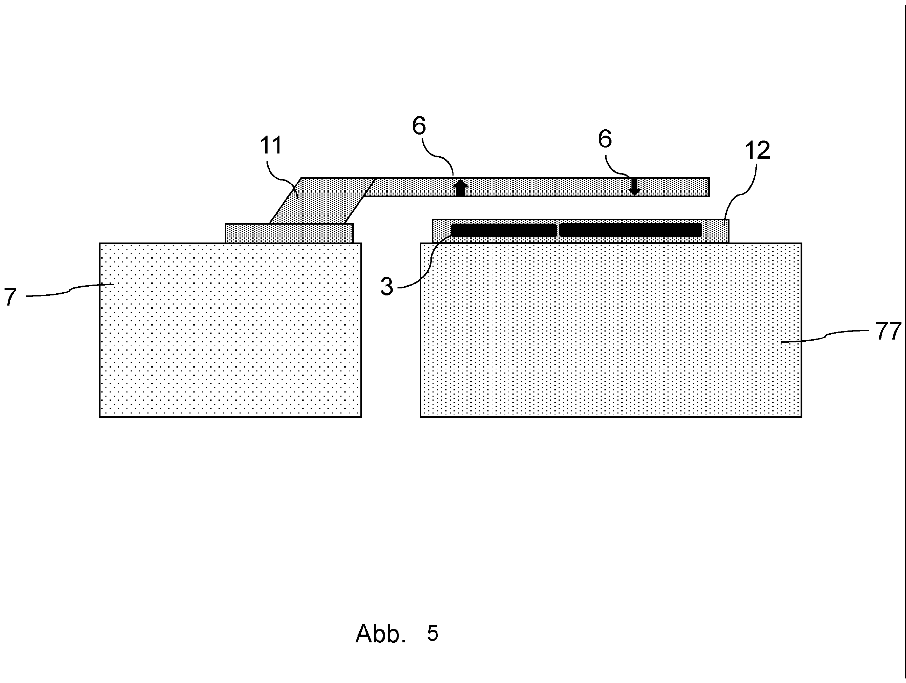

Abb. 5 zeigt eine Ausprägung des in Fig. 1. beschriebenen Sensors zur Messung des Abstandes und der Winkelverdrehung zwischen dem Referenzkörper (77) und dem zu messenden Körper (7), wobei die Permanentmagnete eine antiparallele Magnetisierung aufweisen. Weiters sind Anordnung möglich, wo die Magnetisierung der Permanentmagnete im Allgemeinen nicht kolinear sind.

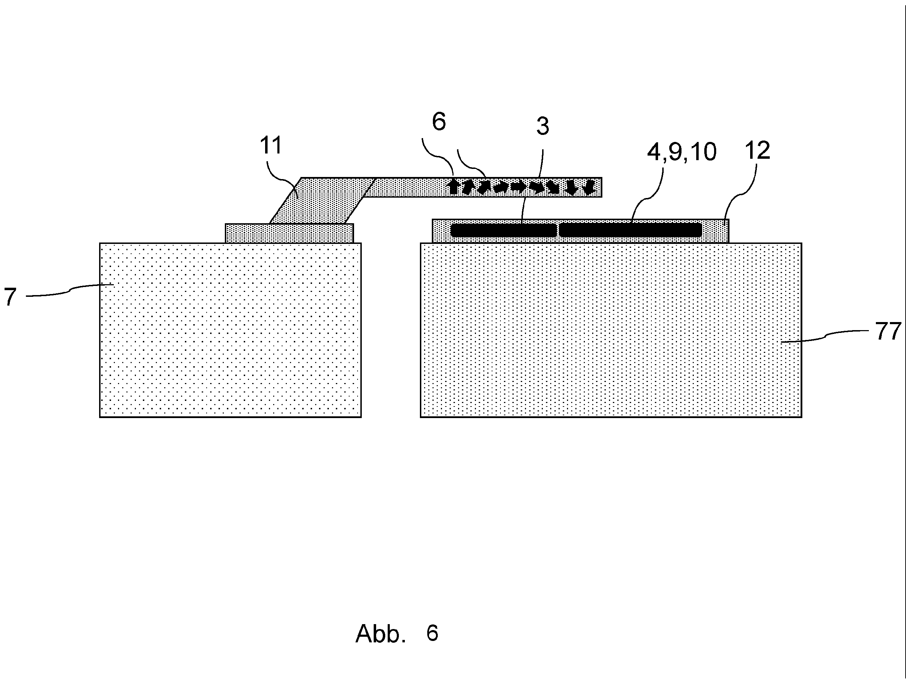

Abb. 6 zeigt eine Ausprägung des in Fig. 1. beschriebenen Sensors zur Messung des Abstandes und der Winkelverdrehung zwischen dem Referenzkörper (77) und dem zu messenden Körper (7), wobei die Permanentmagnete eine Magnetisierung aufweisen, welche gemäß einer Halbach Anordnung magnetisiert sind. Diese Anordnung führt zu einem maximalen magnetischen Feld auf der Seite nahe dem Körper (77) und einem minimalen Feld auf der gegenüberliegenden Seite. Aufgrund des großen magnetischen Feldes werden Störfelder und magnetischen Rauschen der Sensoren minimiert.

Andere magnetische Konfigurationen der Permanentmagnete können aus einem Pseudozufallscode (Pseudo Random Code, PRC) des Permanentmagneten bestehen. Ein Pseudo Random Code der in Längsrichtung auf der Spur angeordnet sind, überlappen sich so, dass die ersten ($N$-1) Bits des aktuellen Codeworts mit den letzten ($N$ -1) Bits des vorherigen Codeworts identisch sind. Beliebige $N$ Bit lange Codewörter also Positionen, können durch Scannen des Pseudo Random Code unter Verwendung eines Fensters der Breite $N$ bestimmt werden.

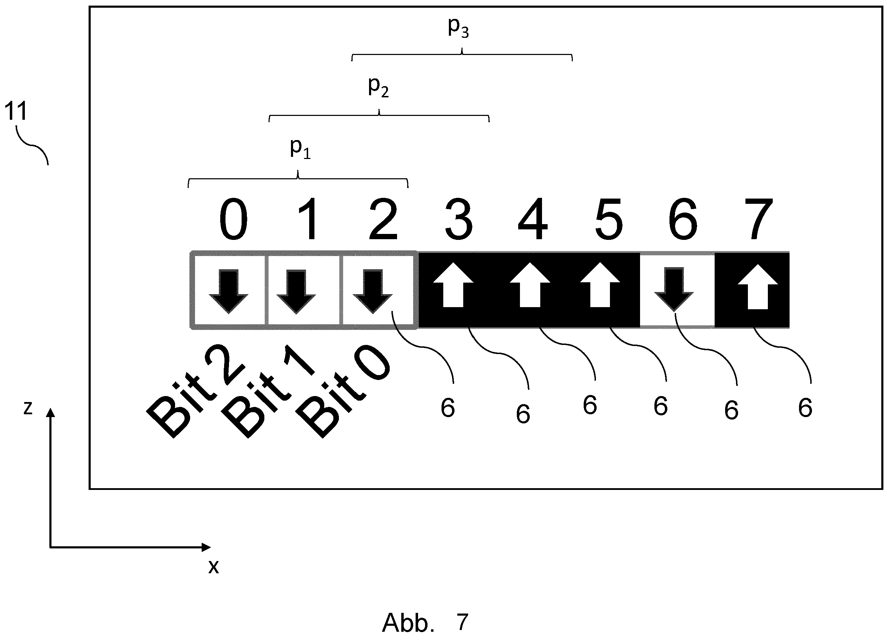

Zum Beispiel sind die Permanentmagnete mit dem Nordpol nach oben (z-Richtung) oder unten (-z Richtung) entsprechend einem PRC angeordnet, wie in Abb. 7 dargestellt ist. Daher kodieren N Bits, die durch die Ausrichtung des Permanentmagneten definiert sind, auf absolute Weise die Position dieser aus N Bits bestehenden Sequenz. Wenn die Sequenz durch das Sensorarray (3) gemessen wird, kann die absolute Position dekodiert werden.

Somit ist die Codierung an jeder Position $p_i$ eindeutig. Wird das Magnetfeld welches aus dieser Codierung entsteht mit den Magnetfeldsensoren (3) ausgelesen kann sowohl auf die Position $p_i$ geschlossen werden, als auch durch die zuvor beschriebene Algorithmen innerhalb der Positionen $p_i$, wie das Sensorarray (3) im Detail relative zu den Permanentmagneten (6) steht. In anderen Worten kann in einem ersten Schritt die grobe Position bestimmt werden auf Grund des eindeutigen Bitmusters des "pseudo Random Codes" und in einem zweiten Schritt mit dem zuvor beschriebenen Algorithmus eine subbinäre Auflösung erreicht werden.

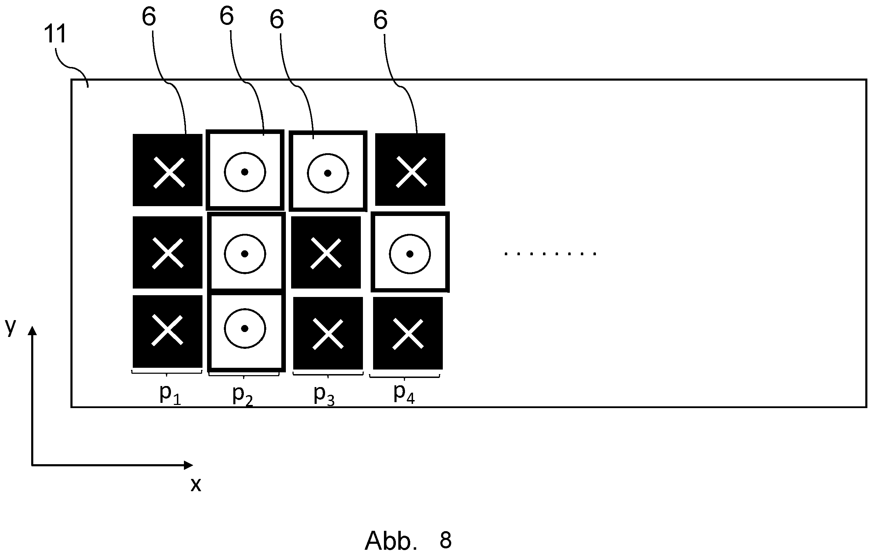

In Abb. 8 ist eine Codierung gezeigt, wo mehr als eine Spur der Permanentmagnete verwendet wird. Hier ist an jeder Position $p_i$ wieder ein eindeutiges Bitmuster realisierbar.

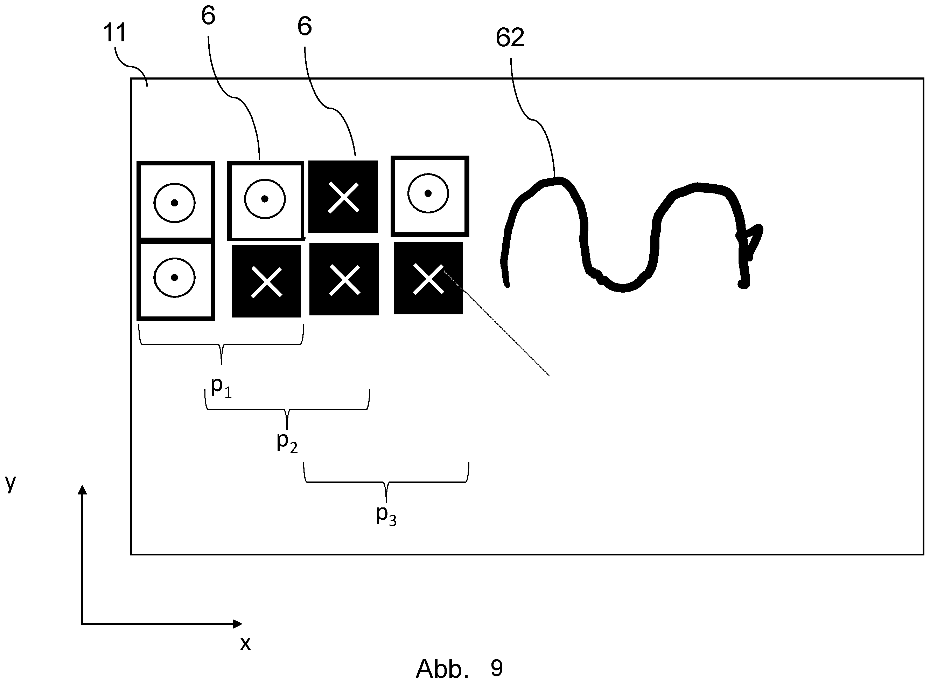

In Abb. 9 ist ein "Pseudo Random Code" dargestellt dir nicht entlang einer Achse abgespult wird, sondern entlang einer Kurve (62) in der x-y Ebene.

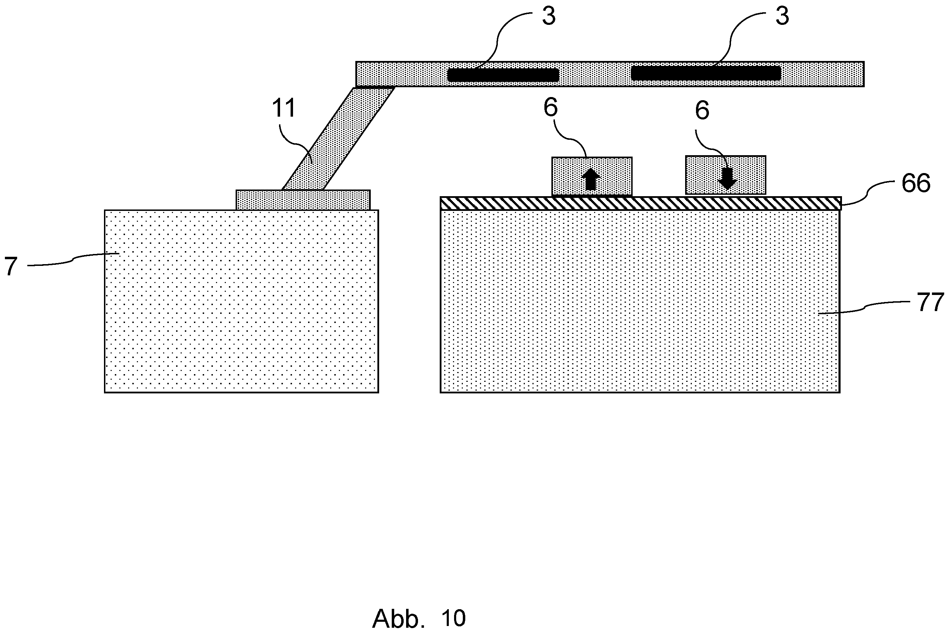

Abb. 10 zeigt eine Ausprägung des in Fig. 1. beschriebenen Sensors zur Messung des Abstandes und der Winkelverdrehung zwischen dem Referenzkörper (77) und dem zu messenden Körpers (7), wobei verglichen mit Fig. 1 die Positionen von Permanentmagneten (6) und Magnetfeldsensoren (3) vertauscht sind. Die Magnetfeldsensoren sind nahe dem Referenzkörper (77) und die Magnetfeldsensoren (3) in weiterer Entfernung und an dem zu messenden Körper (7) fixiert. Dies ist von besonderem Vorteil, falls der Referenzkörper (77) selbst ein magnetisches Material ist, wie beispielsweise Eisen oder Stahl. In der Anwendung ist dies ein wichtiger Fall, wenn beispielsweise Fugen und Verbindungen von Brücken die aus Stahl oder Eisen gefertigt sind gemessen werden sollen. Aufgrund der fixen Position der Magnete (6) und dem Referenzkörper (77) wird das magnetische Feld nicht geändert, falls die Position des zu messende Körper (7) sich ändert. Dies ist nicht der Fall bei der Anordnung wie in Abb. 1 gezeigt. Der Einfluss von magnetischen Störfelder eines magnetischen Referenzkörpers (77) kann reduziert werden, wenn ein weichmagnetisches Element (66) zwischen den Permanentmagneten eingebracht wird. Diese magnetische Abschirmung kann aus Eisen gefertigt sein, Mu - Metall oder eines anderen beliebigen weichmagnetischen Materials. Die intrinsische magnetische Suszeptibilität kann größer als 100 sein.

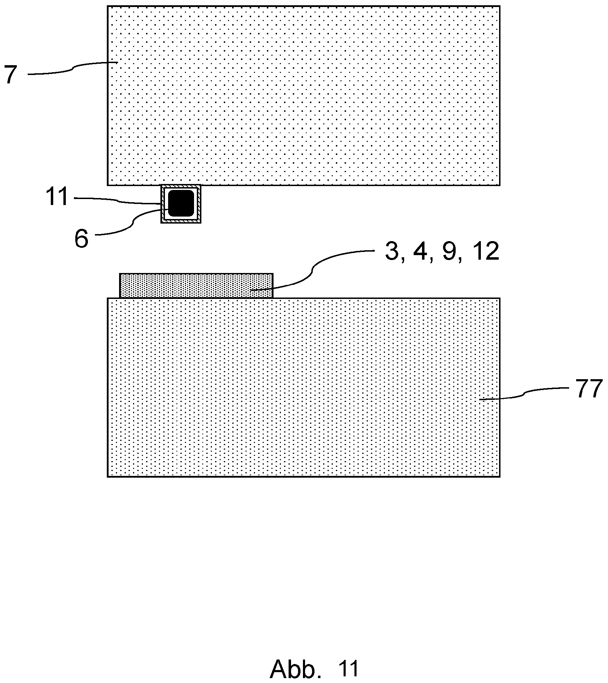

Abb. 11 stellt eine Ausprägung des in Fig. 1. beschriebenen Sensors dar. In diesem Fall ist der zu messende Körper kein starres Objekt, sondern ein Körper, welcher als Funktion äußerer Einflüsse, wie Temperatur oder Druck seine mechanische Form ändert. Ein Beispiel ist, dass der Körper (7) selbst eine Membran besitzt, die als Funktion des Drucks die Form ändert und somit zu einer Änderung der Position des Magnet (6) führt. Diese Positionsänderung kann aufgrund der Magnetfeldänderung durch die Magnetsensoren (3) bestimmt werden.

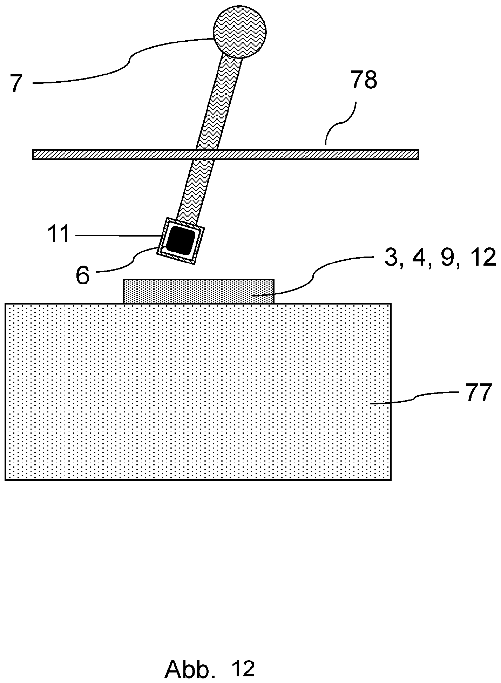

Abb. 12 stellt eine Ausprägung des in Fig. 1. beschriebenen Sensors zur Messung des Abstandes und der Winkelverdrehung zwischen dem Referenzkörper (77) und dem zu messenden Körper (7) dar. Diese Ausprägung stellt den zu messenden Körper (7) als länglichen Zylinder welcher eine Ebene (78) gelagert oder umgelagert durchdringt dar. Ein Beispiel ist die Detektion von Positionen eines Schalters oder die kontinuierliche Detektion der Bewegung eines Hebels.

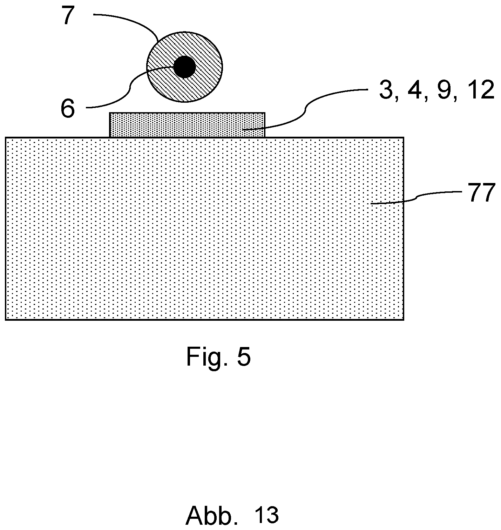

Abb. 13 stellt eine Ausprägung des in Fig. 1. beschriebenen Sensors zur Messung des Abstandes, der Winkelverdrehung und Rotationsgeschwindigkeit zwischen dem Referenzkörper (77) und dem zu messenden Körper (7) dar. Der zu messende Körper (7) rotiert entlang einer Achse.

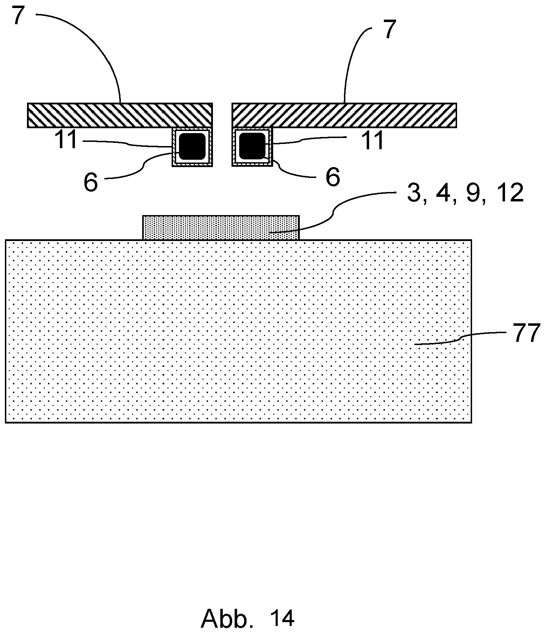

Abb. 14 stellt eine Ausprägung des in Fig. 1. beschriebenen Sensors zur Messung des Abstandes und der Winkelverdrehung zwischen dem Referenzkörper (77) und mehreren zu messende Körper (7) dar. Jeder zu messende Körper (7) wird mit einem Permanentmagneten (6) ausgestattet.

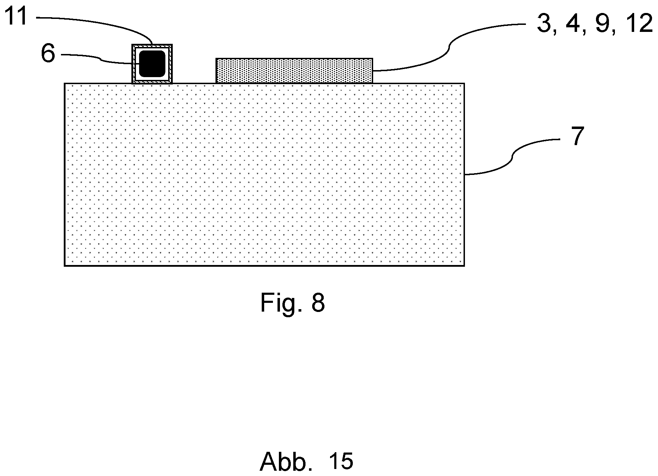

Abb. 15 stellt eine Ausprägung des in Fig. 1 beschrieben Systems dar. In diesem Fall sind das Permanentsystem und die Sensoren (3) auf dem gleichen Körper angebracht. Somit kann eine Längenänderung des zu messenden Körpers (7) detektiert werden. Diese Änderungen beschreiben Dehnung des Materials, aus dem der Körper besteht, welche durch Belastung, Temperatur oder Alterung hervorgerufen werden.

Statt eines Permanentmagneten (2) können z.B. auch Elektromagnete verwendet werden.

Die jeweilige tatsächliche Anordnung der verschiedenen Magnetfeldsensoren (3) und Permanentmagnetsystem (6) kann von gezeigten abweichen. So können z.B. Permanentmagnetsystem (6), Magnetfeldsensor (3), Mikro-Chip (4) und Antenne (9) vertauscht werden. Die Schutzhülle (11, 12), in die der Permanentmagnet (6) oder weitere Komponenten (3, 4, 6, 9, 10) eingebettet ist, kann aus den unterschiedlichsten Materialien bestehen, solange die elektromagnetischen Wellen nicht verfälscht oder merklich gedämpft werden. Kunststoffe wie Thermoplaste, Duroplaste, Elastomere sind besonders bevorzugt. Bei Hochtemperaturanwendungen können feuerfeste Keramiken wie Verbindungen von Silicat-Rohstoffen, Verbindungen auf der Basis von Magnesit, Si-Oxide, Aluminiumoxid, Siliciumcarbid, Bornitrid, Zirkonoxid, Siliziumnitrid, Aluminiumnitrid, Wolframcarbid und Aluminiumtitanat verwendet werden.

Als Magnetfeldsensoren können Hall Sensoren, AMR, Sensoren, GMR Sensoren und TMR Sensoren, Magnetoimpetanzsensoren oder Squid Sensoren verwendet werden. Bei TMR und GMR Sensoren sind Sensoren besonderes geeignet die einen Vortexzustand in der freien magnetischen Schicht zeigen (US20150185297A1).

Magnetische Materialien für die Permanentmagneten können gesinterte Magnete, polymergebundene Magnete oder auch durch additive Fertigung hergestellte Magnete sein (Huber, C., et al. Applied Physics Letters 109.16 (2016): 162401). Beispiel für hartmagnetische Materialien sind, seltene Erdmagnete (NdFeB,SmFeB), magnetische Ferrite (Sr-Fe,Ba-Fe), Alnico-Magnete.

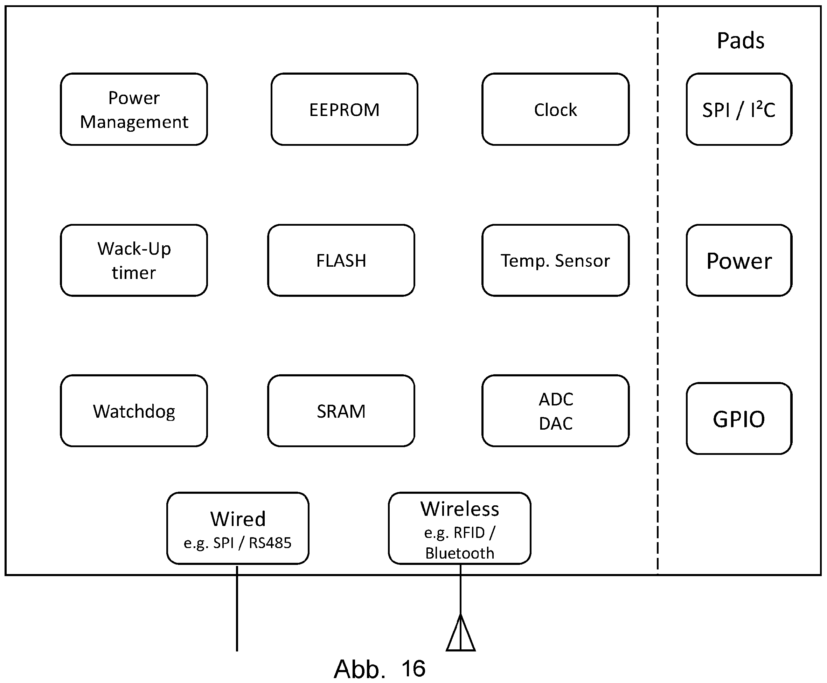

In Abb. 16. sind die typischen Bestandteile des Mikro-Chips inklusive drahtgebundener Kommunikation sowie drahtloser Kommunikation dargestellt. Dieser beinhaltet optional einen Speicher, wie zum Beispiel EEPROM ("electrically erasable programmable read-only memory"), optional eine Batterie, eine Antenne, einen elektronischen Produktcode (EPC), optional einen Temperatursensor, einen Multiplexer und optional eine Echtzeituhr RTC ("real time clock"). Die Übertragungsfrequenz bei drahtloser Kommunikation kann ISM (2,4Ghz), UHF (0.3 bis 3 GHz), HF (3 bis 30 MHz) sein, oder auch jede andere übliche Betriebsfrequenz. Bevorzugte RF Trägerfrequenzen sind zwischen 12 MHz - 14 MHz (NFC) und 860-970 MHz (UHF).

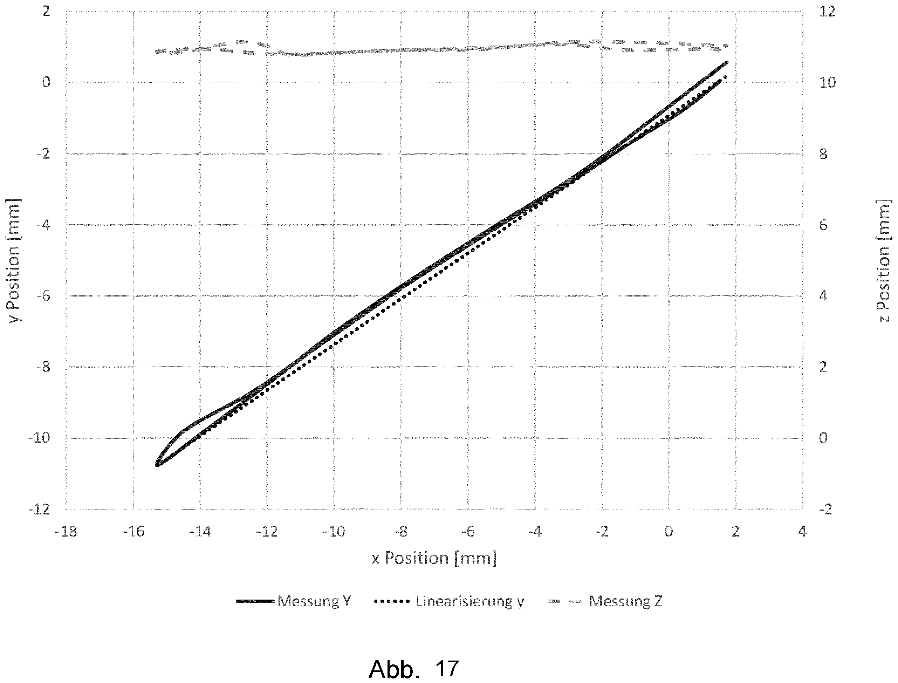

Abb. 17 zeigt einen Graph, der die Abhängigkeit der gemessene Position des Sensors angibt. In diesem Fall wurde der zu messende Körper entlang einer Geraden bewegt.

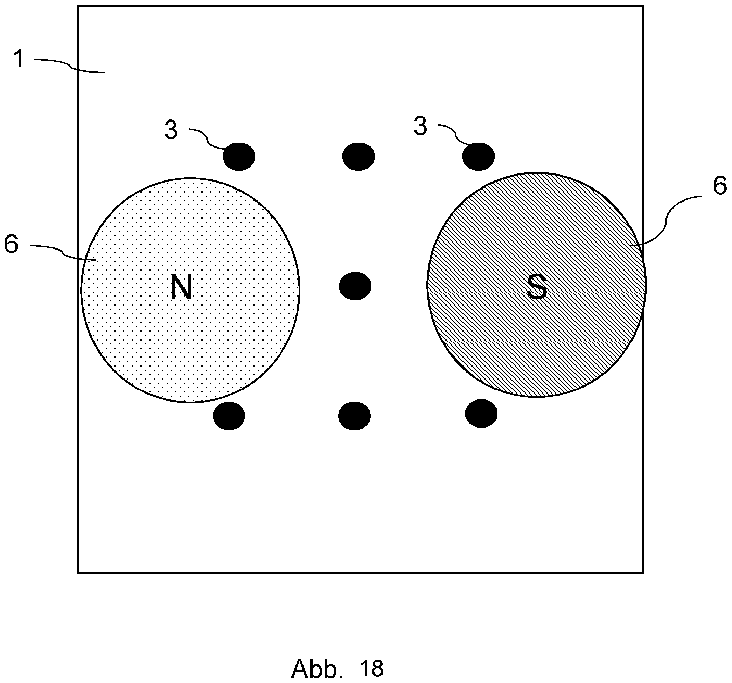

Abb. 18 zeigt eine mögliche geometrische Anordnung der Sensoren. Hier ist der Abstand der äußersten Sensoren 30 mm. Das Sensorarray (3) besteht aus (3x3 Sensoren). Es werden zwei Magnete mit entgegengesetzter Magnetisierung verwendet. Die Magnete haben eine Dimension von Radius = 4 mm, Höhe =10 mm und die Sättigungspolarisation ist $J_s$ = 1 T. Der laterale Abstand der Magnete (Kante zu Kante) ist 5 mm. Der Abstand der Oberfläche der Magnete zu der Oberfläche der Sensoren ist 3 mm. Das Sensorrauschen $B_{Rauschen}$ (rms) beträgt $B_{Rauschen}$ = 1 mT.

Mögliche Geometrien und Anordnungen der Magnete und Sensoren sind welche, wo die kleinste laterale Ausdehnung von zumindest einem Permanentmagneten größer als 0.2 mal dem mittlere Abstand der Sensoren (3) ist und der Abstand der Mittelpunkte der Magnete größer als 0.2 mal dem mittlere Abstand der Sensoren ist. Solche Anordnungen führen aufgrund der hohen Feldgradienten zu einer genauen Bestimmung der Ausrichtung im Raum.

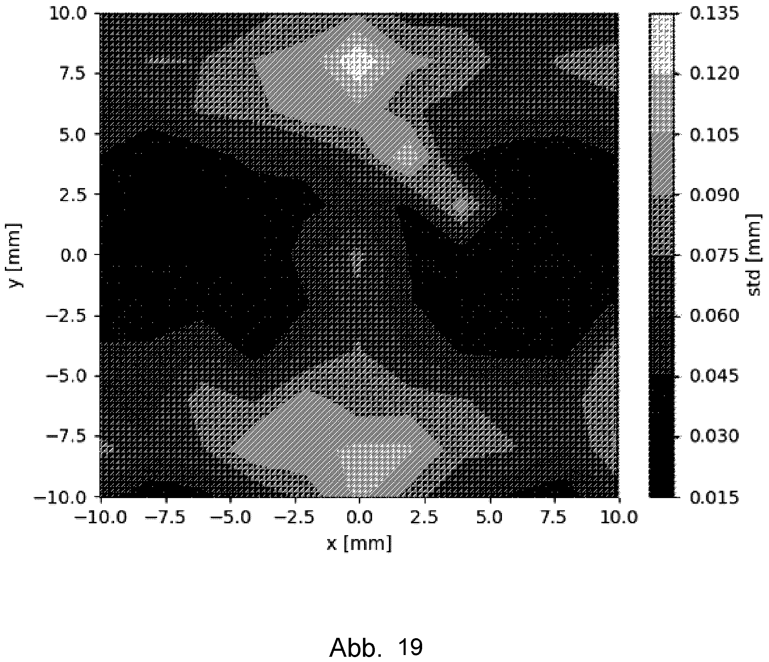

In Abb. 19 ist die Standardabweichung der bestimmten x-Position für verschiedene Positionen des zu messende Körper (7) bestimmt. Der zu messende Körper wurde in einem Bereich von 20 mm in x-Richtung und y-Richtung platziert. Die maximale Ungenauigkeit ist ca. 0.6% vom Messbereich.

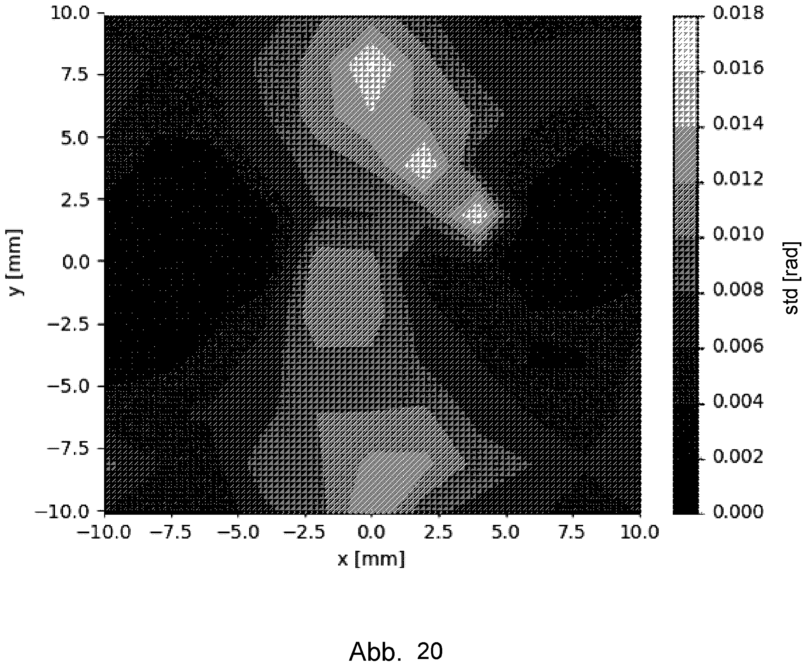

Abb. 20 ist die Standardabweichung des Drehwinkels um die z-Achse für verschiedene Positionen des zu messende Körper (7) bestimmt. Der zu messende Körper wurde in einem Bereich von 20 mm in x-Richtung und y-Richtung platziert. Die maximale Ungenauigkeit des Drehwinkels beträgt 0.018 rad, das ca. 1° entspricht.

Es sind auch unterschiedliche Kombinationen der gezeigten und beschriebenen Elemente möglich und es können in Zukunft selbstverständlich auch neue Materialien, die die angeführten Eigenschaften besitzen, verwendet werden, auch wenn unter Umständen deren Benennung nicht mit der derzeit üblichen übereinstimmt. Der Grund für diese explizite Feststellung ist, dass sich gerade die Materialwissenschaften in rascher Entwicklung befinden und daraus keine Einschränkung des Schutzes abgeleitet werden soll.

## Patentansprüche

1. Verfahren zum Messen des Ausrichtungsvektors $y_{Magnet}$ zwischen zwei Körpern (7, 77), wobei zumindest zwei Magnetfeldsensoren (3) auf einem Körper (77) angebracht sind und auf einem anderen Körper (7) ein Magnetsystem angebracht ist, welches aus zumindest einem Permanentmagneten (6) besteht, wobei die Permanentmagnete an den Positionen der Sensoren ein Magnetfeld $H_{Messung}$, erzeugen, und zumindest eine Komponente des Magnetfeldes von zumindest zwei Sensoren (3) gemessen wird, **dadurch gekennzeichnet, dass** der Ausrichtungsvektor des Magnetsystems $y_{Magnet}$ bestimmt wird, indem bei bekannter Geometrie, Anordnung und Magnetisierungsrichtung der Permanentmagnete für eine bestimmte Ausrichtung des Magnetsystems das erwartete Magnetfeld $H_{\text{Theorie}}(y_{\text{Magnet}})$ an den Orten der Sensoren berechnet wird, wobei die Anzahl der gemessenen Feldwerte der Sensoren (3) größer als die Anzahl der Komponenten des Vektors $y_{\text{Magnet}}$ ist und die Differenz $d(y_{\text{Magnet}}) = H_{\text{Theorie}}(y_{\text{Magnet}}) - H_{\text{Messung}}$ des theoretischen Feld $H_{\text{Theorie}}(y_{\text{Magnet}})$ und des gemessenen Feldes $H_{\text{Messung}}$ bestimmt wird und der Ausrichtungsvektor des Magnetsystems $y_{\text{Magnet}}$ (6) derart bestimmt, dass eine mathematische Norm des Vektors $d$ minimiert wird und somit der Ausrichtungsvektor $y_{\text{Magnet}}$ des Permanentmagnetsystems (6) bestimmt werden kann.

2. Verfahren nach Anspruch 1, **dadurch gekennzeichnet, dass** der Startwert des Ausrichtungsvektors $y_{\text{Magnet}}$ zwischen den zwei Körpern (7, 77) gemessen wird, wobei der Ausrichtungsvektor des Magnetsystems $y_{\text{Magnet}}$ bestimmt wird, indem bei bekannter Geometrie, Anordnung und Magnetisierungsrichtung der Permanentmagnete für eine bestimmte Ausrichtung des Magnetsystems das erwartete Magnetfeld $H_{\text{Theorie}}(y_{\text{Magnet}})$ an den Orten der Sensoren bestimmt wird und für eine Vielzahl von Ausrichtungen $y_{\text{Magnet}}$ eine "Machine Learning" Methode angelernt wird, die für $H_{\text{Theorie}}$ eine Approximation für $y_{\text{Magnet}}$ liefert und diese angelernte "Machine Learning" Methode verwendet wird, um aus dem gemessenen Feld $H_{\text{Messung}}$ eine Approximation für $y_{\text{Magnet}}$ zu liefern.

3. Verfahren nach Anspruch 1 oder Anspruch 2, **dadurch gekennzeichnet, dass** der Ausrichtungsvektor des Magnetsystems $y_{\text{Magnet}}$ nur die örtlichen Verschiebungen im Raum beinhaltet, also $y_{\text{Magnet}}=x_{\text{Magnet}}$.

4. Verfahren nach Anspruch 1, 2 oder 3, **dadurch gekennzeichnet, dass** aus dem Ausrichtungsvektor des Magnetsystems $y_{\text{Magnet}}$ die Distanz zwischen zwei Körpern (7, 77) bestimmt wird.

5. Verfahren nach einem der vorhergehenden Ansprüche, **dadurch gekennzeichnet, dass** zwischen den Permanentmagneten (6) und dem Körper (7) eine weichmagnetische Abschirmung angebracht ist.

6. Verfahren nach einem der vorhergehenden Ansprüche, **dadurch gekennzeichnet, dass** das theoretische Feld mit einem Faktor $\xi$ skaliert wird, und dieser Faktor in der Minimierung des Abstandes $d$ mitbestimmt wird.

7. Verfahren nach einem der vorhergehenden Ansprüche, **dadurch gekennzeichnet, dass** zumindest ein Permanentmagnet eine nicht parallele Magnetisierung bezüglich einen der anderen Permanentmagneten aufweist.

8. Verfahren nach einem der vorhergehenden Ansprüche, **dadurch gekennzeichnet, dass** die Magnetisierung eines Permanentmagneten einen "pseudo random code" besteht.

9. Verfahren nach einem der vorhergehenden Ansprüche, **dadurch gekennzeichnet, dass** mindestens eine der Methoden wie neuronale Netze, "Gradient Boost" verwendet wird.

10. Verfahren nach einem der vorhergehenden Ansprüche, **dadurch gekennzeichnet, dass** für das Anlernen des erwartete Magnetfeld $H_{\text{Theorie}}(y_{\text{Magnet}})$ bei einem bestimmen Ausrichtungsvektor $y_{\text{Magnet}}$ Messwerte verwendet werden, die bestimmt werden, indem physikalisch die Ausrichtung des Magnetfeldsystems (6) relativ zum Sensorarray (3) verändert wird und der Vektor $y_{\text{Magnet}}$ bekannt ist und die Werte $H_{\text{Theorie}}(y_{\text{Magnet}})$ durch das Auslesen der Magnetfeldsensoren (3) bestimmt werden.

11. Verfahren nach einem der Ansprüche 1 bis 9, **dadurch gekennzeichnet, dass** das erwartete Magnetfeld $H_{\text{Theorie}}(y_{\text{Magnet}})$ an den Orten der Sensoren durch eine analytische oder numerische Berechnung des Magnetfeldes bestimmt wird.

12. Verfahren nach Anspruch 2, **dadurch gekennzeichnet, dass** beim Anlernen auch Werte aus Verfahren aus Anspruch 10 verwendet werden.

**Claims**

1. A method for measuring the orientation vector $y_{\text{magnet}}$ between two bodies (7, 77), at least two magnetic field sensors (3) being attached to one body (77), and a magnetic system being attached to another body (7), which consists of at least one permanent magnet (6), said permanent magnets generating a magnetic field $H_{\text{measurement}}$ at the positions of the sensors, and wherein at least one component of the magnetic field is measured by at least two sensors (3), **characterized in that** the orientation vector of the magnetic system $y_{\text{Magnet}}$ is determined by calculating the expected

magnetic field $H_{\text{theory}}(\mathbf{y}_{\text{magnet}})$ at the positions of the sensors at a known geometry, positioning and magnetizing direction of the permanent magnets for a certain orientation of the magnetic system, the number of field values of the sensors (3) measured being higher than the number of components of the vector $\mathbf{y}_{\text{magnet}}$, and that the difference $d(\mathbf{y}_{\text{magnet}}) = H_{\text{theory}}(\mathbf{y}_{\text{magnet}}) - H_{\text{measurement}}$ between the theoretical field $H_{\text{theory}}(\mathbf{y}_{\text{magnet}})$ and the measured field $H_{\text{measurement}}$ is determined, and that the orientation vector of the magnetic system $\mathbf{y}_{\text{Magnet}}$ (6) is determined, such that a mathematical norm of the vector d is minimized and, thus, the orientation vector $\mathbf{y}_{\text{Magnet}}$ of the permanent magnet system (6) can be determined.

2. The method according to Claim 1, **characterized in that** the starting value of the orientation vector $\mathbf{y}_{\text{magnet}}$ between the two bodies (7, 77) is measured, whereby the orientation vector of the magnetic system $\mathbf{y}_{\text{Magnet}}$ is determined by calculating the expected magnetic field $H_{\text{theory}}(\mathbf{y}_{\text{magnet}})$ at the positions of the sensors at a known geometry, positioning and magnetizing direction of the permanent magnets for a certain orientation of the magnetic system, and for a plurality of orientations $\mathbf{y}_{\text{magnet}}$, a machine learning method is trained, providing an approximation of $H_{\text{theory}}$ for $\mathbf{y}_{\text{magnet}}$, and said trained machine learning method being used for providing an approximation for $\mathbf{y}_{\text{magnet}}$ from the measured field $H_{\text{measurement}}$.

3. The method according to Claim 1 or Claim 2, **characterized in that** the orientation vector of the magnetic system $\mathbf{y}_{\text{Magnet}}$ only contains the positional shifts in space, i.e. $\mathbf{y}_{\text{magnet}} = \mathbf{X}_{\text{magnet}}$.

4. The method according to Claim 1, 2 or 3, **characterized in that** the distance between two bodies (7, 77) is determined from the orientation vector of the magnetic system $\mathbf{y}_{\text{magnet}}$.

5. The method according to any one of the previous Claims, **characterized in that** between the permanent magnets (6) and the body (7), a magnetically soft shield is arranged.

6. The method according to any one of the previous Claims, **characterized in that** the theoretical field is scaled by a factor $\xi$, and that this factor is also determined during minimizing the distance $d$.

7. The method according to any one of the previous Claims, **characterized in that** at least one permanent magnet has one non-parallel magnetization relative to one of the other permanent magnets.

8. The method according to any one of the previous Claims, **characterized in that** the magnetization of a permanent magnet passes a "pseudo random code".

9. The method according to any one of the previous Claims, **characterized in that** at least one of the methods such as neural networks, "gradient boost" is used.

10. The method according to any one of the previous Claims, **characterized in that,** for training, the expected magnetic field $H_{\text{theory}}(\mathbf{y}_{\text{magnet}})$ at a certain orientation $\mathbf{y}_{\text{magnet}}$, measurement values are used which are determined by physically changing the orientation of the magnetic system (6) relative to the sensor array (3), and that the vector $\mathbf{y}_{\text{magnet}}$ is known, and that the values $H_{\text{theory}}(\mathbf{y}_{\text{magnet}})$ are determined by a read-out of the magnetic field sensors (3).

11. The method according to any one of Claims 1 to 9, **characterized in that** the expected magnetic field $H_{\text{theory}}(\mathbf{y}_{\text{magnet}})$ at the positions of the sensors is determined by an analytical or numerical calculation of the magnetic field.

12. The method according to Claim 2, **characterized in that,** for training, also values according to Claim 10 are used.

**Revendications**

1. Procédé pour mesurer le vecteur d'orientation $\mathbf{y}_{\text{aimant}}$ entre deux corps (7, 77), au moins deux capteurs de champ magnétique (3) étant attachés à un corps (77) et un système magnétique étant attaché à un autre corps (7), ledit système magnétique comprenant au moins un aimant permanent (6), lesdits aimants permanents créant un champ magnétique $H_{\text{mesure}}$ dans les positions des capteurs, et au moins une composante dudit champ magnétique étant mesurée par au moins deux capteurs (3), **caractérisé en ce que** le vecteur d'orientation dudit système magnétique $\mathbf{y}_{\text{aimant}}$ est déterminé en calculant le champ magnétique attendu $H_{\text{théorie}}(\mathbf{y}_{\text{aimant}})$ pour une certaine orientation dudit système magnétique dans les positions desdits capteurs, compte tenu d'une géométrie, disposition et direction de magnétisation connues desdits aimants permanents, le nombre des valeurs de champ mesurées desdits capteurs (3) étant supérieur au nombre des composantes du vecteur $y_{aimant}$ et que la différence $d(y_{aimant})$ = Hthéorie(Yaimant) - $H_{mesure}$ entre ledit champ théorique $H_{théorie}(y_{aimant})$ et ledit champ mesuré $H_{mesure}$ étant déterminée et ledit vecteur d'orientation dudit système magnétique $y_{aimant}$ (6) étant déterminé de sorte qu'une norme mathématique du vecteur $d$ est minimisée, et ledit vecteur d'orientation $y_{aimant}$ dudit système d'aimant(s) permanent(s) (6) pouvant ainsi être déterminé.

2. Procédé selon la revendication 1, **caractérisé en ce que** la valeur de départ dudit vecteur d'orientation $y_{aimant}$ entre lesdits deux corps (7, 77) est mesurée, ledit vecteur d'orientation du système magnétique $y_{aimant}$ étant déterminé en calculant le champ magnétique attendu $H_{théorie}(y_{aimant})$ pour une certaine orientation dudit système magnétique dans les positions desdits capteurs, compte tenu d'une géométrie, disposition et direction de magnétisation connues desdits aimants permanents, et une méthode d'apprentissage automatique étant apprise pour une pluralité d'orientations $y_{aimant}$, fournissant une approximation pour $H_{théorie}$ pour $y_{aimant}$, ladite méthode d'apprentissage automatique apprise étant utilisée pour fournir une approximation pour $y_{aimant}$ à partir du champ mesuré $H_{mesure}$.

3. Procédé selon les revendications 1 ou 2, **caractérisé en ce que** ledit vecteur d'orientation dudit système magnétique $y_{aimant}$ comprend uniquement les changements de position spatiaux, c'est à dire $y_{aimant} = x_{aimant}$.

4. Procédé selon l'une quelconque des revendications 1, 2 ou 3, **caractérisé en ce que** la distance entre deux corps (7, 77) est déterminée à partir dudit vecteur d'orientation dudit système magnétique $y_{aimant}$.

5. Procédé selon l'une quelconque des revendications précédentes, **caractérisé en ce qu'**un écran à magnétisme doux est monté entre lesdits aimants permanents (6) et ledit corps (7).

6. Procédé selon l'une quelconque des revendications précédentes, **caractérisé en ce que** ledit champ théorique est mis à l'échelle par un facteur ξ et **en ce que** ce facteur est également déterminé lors de la minimisation de la distance $d$.

7. Procédé selon l'une quelconque des revendications précédentes, **caractérisé en ce qu'**au moins un desdits aimants permanents présente une magnétisation non parallèle par rapport à un autre parmi lesdits aimants permanents.

8. Procédé selon l'une quelconque des revendications précédentes, **caractérisé en ce que** la magnétisation d'un parmi lesdits aimants permanents passe un code pseudo-aléatoire.

9. Procédé selon l'une quelconque des revendications précédentes, **caractérisé en ce qu'**au moins une méthode telle que celle des réseaux neuronaux et d'amplification de gradient est utilisée.

10. Procédé selon l'une quelconque des revendications précédentes, **caractérisé en ce que** pour l'apprentissage dudit champ magnétique attendu $H_{théorie}(y_{aimant})$ face à une orientation déterminée $y_{aimant}$ sont utilisées des valeurs mesurées déterminées en changeant de façon physique l'orientation dudit système du champ magnétique (6) par rapport à l'ensemble des capteurs (3), et que le vecteur $y_{aimant}$ étant connu et les valeurs $H_{théorie}(y_{aimant})$ étant déterminées en lisant les capteurs (3) du champ magnétique.

11. Procédé selon l'une quelconque des revendications 1 à 9, **caractérisé en ce que** ledit champ magnétique attendu $H_{théorie}(y_{aimant})$ dans les positions desdits capteurs est déterminé par un calcul analytique ou numérique du champ magnétique,

12. Procédé selon la revendication 2, **caractérisé en ce que** lors de l'apprentissage sont utilisées également des valeurs issues de procédés selon la revendication 10.

EP 3 792 587 B1

Abb. 2

Abb. 3

Abb. 4

Abb. 5

Abb. 6

EP 3 792 587 B1

Abb. 7

Abb. 8

EP 3 792 587 B1

Abb. 9

Abb. 10

EP 3 792 587 B1

7

11

6

3, 4, 9, 12

77

Abb. 11

Abb. 12

Fig. 5

Abb. 13

Abb. 14

Fig. 8

Abb. 15

| Pads | | |
|---|---|---|
| SPI / I²C | Clock | EEPROM |
| Power | Temp. Sensor | FLASH |
| GPIO | ADC DAC | SRAM |

Power Management

Wack-Up timer

Watchdog

Wireless
e.g. RFID /
Bluetooth

Wired
e.g. SPI / RS485

Abb. 16

Abb. 17

Abb. 18

Abb. 19

Abb. 20

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- SE 9501500 A
- WO 2004070408 A
- JP 2005338031 A
- JP 8293012 A
- US 2002166382 A
- DE 10038296 A1
- US 20180306601 A1
- DE 102015203686 A1
- US 20150185297 A1

**In der Beschreibung aufgeführte Nicht-Patentliteratur**

- Application of 3D-printed magnets for magnetic position detection systems. **ORTNER, M. et al.** 2017 IEEE SENSORS. IEEE, 2017
- **HUBER, C. et al.** *Applied Physics Letters,* 2016, vol. 109 (16), 162401